# EUROPEAN PATENT APPLICATION

(11) **EP 4 033 519 A1**
(43) Date of publication of application: **27.07.2022**
(21) Application number: 20864989.7
(22) Date of filing: 18.06.2020
(51) Int. Cl.: H01L 21/324, H01L 29/78, H01L 29/12, H01L 21/336

(54) **SEMICONDUCTOR DEVICE AND METHOD FOR MANUFACTURING SAME**

(30) Priority: 18.09.2019 JP 2019169383
(71) Applicant: Hitachi, Ltd., Tokyo 100-8280 (JP); Toyo Tanso Co., Ltd., Osaka-shi, Osaka 555-0011 (JP)
(72) Inventor: KOBAYASHI, Keisuke, Tokyo 100-8280 (JP); KONISHI. Kumiko, Tokyo 100-8280 (JP); SHIMA, Akio, Tokyo 100-8280 (JP); YABUKI, Norihito, Kanonji-shi Kagawa 769-1612 (JP); SUDOH, Yusuke, Kanonji-shi Kagawa 769-1612 (JP); NOGAMI, Satoru, Kanonji-shi Kagawa 769-1612 (JP); KITABATAKE, Makoto, Osaka-shi Osaka 555-0011 (JP)
(74) Representative: Strehl Schübel-Hopf & Partner
(86) International application number: PCT/JP2020/024033
(87) International publication number: WO 2021/053906

(57) **Abstract**

To provide a technique capable of improving performance and reliability of a semiconductor device. An n⁻-type epitaxial layer (12) is formed on an n-type semiconductor substrate (11), and a p⁺-type body region (14), n⁺-type current spreading regions (16, 17), and a trench TR are formed in the n⁻-type epitaxial layer (12). A bottom surface B1 of the trench TR is located in the p⁺-type body region (14), a side surface S1 of the trench TR is in contact with the n⁺-type current spreading region (17), and a side surface S2 of the trench TR is in contact with the n⁺-type current spreading region (16). Here, a ratio of silicon is higher than a ratio of carbon in an upper surface T1 of the r⁻-type epitaxial layer (12), and the bottom surface B1, the side surface S1, and the side surface S2 of the trench. Furthermore, an angle θ1 at which the upper surface T1 of the n⁻-type epitaxial layer (12) is inclined with respect to the side surface S1 is smaller than an angle θ2 at which the upper surface T1 of the n⁻-type epitaxial layer (12) is inclined with respect to the side surface S2.

## Description

### Technical Field

The present invention relates to a semiconductor device and a method for manufacturing the same, and particularly relates to a semiconductor device using silicon carbide.

### Background Art

In a metal insulator semiconductor field effect transistor (MISFET) that is one of power semiconductor devices, a power MISFET (Si power MISFET) using a silicon (Si) substrate is mainly used in the related art. However, an electric field strength for dielectric breakdown in silicon carbide (SiC) is about one order of magnitude larger than that in Si.

Therefore, in a power MISFET (SiC power MISFET) using a SiC substrate, a thickness of a drift layer for maintaining a breakdown voltage can be reduced to about one-tenth and an impurity concentration of the drift layer can be increased by about one hundred times as compared with the Si power MISFET. As a result, in the SiC power MISFET, an element resistance can be theoretically reduced by three orders of magnitude or more. In addition, since SiC has a band gap that is about three times larger than that of Si, the SiC power MISFET can reduce an on-resistance at the same breakdown voltage and can also operate in a high-temperature environment. Therefore, a SiC semiconductor element is expected to have performance exceeding that of a Si semiconductor element.

For example, PTL 1 discloses, as an example of the SiC power MISFET, a double diffused metal oxide semiconductor (DMOS) structure using a front surface of a 4H-SiC substrate as a channel.

PTL 2 proposes a structure in which a channel current flows in a longitudinal direction with respect to a substrate by forming a trench reaching a drift layer so as to penetrate a p-type body layer withstanding a breakdown voltage. However, since a dielectric breakdown strength of SiC is large and is about seven times that of Si, a strength of an electric field applied to a gate insulating film formed on a bottom surface of the trench is seven times that of Si at the time of blocking. As a result, since a dielectric breakdown voltage of the gate insulating film is exceeded, dielectric breakdown is likely to occur.

In PTL 3, in order to avoid breakdown of the gate insulating film at the time of blocking, a trench is formed in a substrate having a (0001) plane such that a groove is formed inside a body layer. Therefore, an effective channel width can be widened by using a (11-20) plane or a (1-100) plane having high channel mobility. A structure obtained by such a method may also be referred to as a trench type DMOS.

PTL 4 discloses a method for relaxing electric field concentration by forming an inclined surface at a corner portion of a trench.

PTL 5 discloses a method for relaxing electric field concentration by thermally oxidizing a corner portion of a trench with a local oxidation of silicon (LOCOS) method.

### Citation List

### Patent Literature

PTL 1: JP-A-2013-236040
PTL 2: JP-A-2009-260253
PTL 3: WO2015/177914
PTL 4: JP-A-2016-48747
PTL 5: JP-A-2003-124466

### Summary of Invention

### Technical Problem

In a (0001) plane in PTL 1, channel mobility is about one-fifth of that of a Si power MISFET and is extremely low. Therefore, a parasitic resistance of a channel increases, which is a big issue. As an effective means for reducing the parasitic resistance of the channel, using a (11-20) plane or a (1-100) plane in which high channel mobility is obtained is studied. In order to use the (11-20) plane or the (1-100) plane, a MISFET having a trench structure needs to be formed on a substrate having the (0001) plane.

In a trench structure disclosed in PTL 2 or PTL 3, after a trench is formed, flatness of a bottom surface and a side surface of the trench is poor and damage caused by dry etching remains. Therefore, roughness scattering is increased, and the channel mobility is decreased. In addition, since the channel mobility is decreased by an impurity level formed due to the damage caused by the dry etching, an on-resistance increases. In addition, when flatness of a surface serving as a channel in the trench is poor, a dielectric breakdown lifetime of a gate insulating film is shortened. In addition, when a gate voltage is applied, an electric field is concentrated at a corner portion formed by the side surface of the trench and an upper surface of a SiC substrate, so that a leakage current is likely to be generated. This also causes shortening of the dielectric breakdown lifetime of the gate insulating film. That is, there is a concern about a decrease in reliability of a semiconductor device.

In addition, PTL 4 discloses a technique of using crystal anisotropic etching or physical anisotropic etching in order to form an inclined surface at a corner portion formed by a side surface of a trench and an upper surface of a SiC substrate, but these etchings are very difficult to be controlled. Further, there arises a problem of a variation in channel length due to a variation in dry etching or misalignment of respective layers during exposure.

In addition, PTL 5 discloses a technique of using an oxidation method in order to smooth a corner portion formed by a side surface of a trench and an upper surface of a Si substrate, but the oxidation is also very difficult to be controlled, and there arises a problem of a variation in channel length. The variation in channel length is a variation in threshold voltage among chips provided in a power module or a variation in on-resistance, and appears as a variation in performance among the chips.

In particular, since a percentage of a channel resistance in the on-resistance is large in a low breakdown voltage SiC power MISFET for automobiles and industries, the problem of the variation in performance among the chips caused by the variation in channel length or an increase in on-resistance caused by a decrease in channel mobility is remarkable.

Therefore, in order to solve these problems, after the trench is formed, the flatness of the bottom surface and the side surface of the trench needs to be improved and the damage caused by the drying etching needs to be removed. As a result, it is expected that a low resistance of the channel is maintained and dielectric breakdown of the gate insulating film is prevented in the MISFET having the trench structure.

Other problems and novel features will be apparent from a description of the description and accompanying drawings.

### Solution to Problem

An outline of a representative one of embodiments disclosed in the present application will be briefly described as follows.

A semiconductor device according to an embodiment includes: a semiconductor substrate of a first conductivity type made of silicon carbide; a first semiconductor layer of the first conductivity type formed on the semiconductor substrate and made of silicon carbide; and a first impurity region of a second conductivity type formed in the first semiconductor layer, the second conductivity type being opposite to the first conductivity type. The semiconductor device further includes: a second impurity region of the first conductivity type and a third impurity region of the first conductivity type each formed in the first impurity region and having an impurity concentration higher than that of the first semiconductor layer; a trench formed so as to penetrate the second impurity region and the third impurity region; and a gate electrode formed in the trench with a gate insulating film interposed between the gate electrode and the trench. Here, the trench has a bottom surface located in the first impurity region, a first side surface in contact with the second impurity region, and a second side surface in contact with the third impurity region and facing the first side surface. In addition, a ratio of silicon is higher than a ratio of carbon in an upper surface of the first semiconductor layer outside the trench, and the bottom surface, the first side surface, and the second side surface of the trench. An angle θ1 at which the upper surface of the first semiconductor layer on a first side surface side is inclined with respect to the first side surface is smaller than an angle θ2 at which the upper surface of the first semiconductor layer on a second side surface side is inclined with respect to the second side surface.

### Advantageous Effect

According to an embodiment, performance and reliability of a semiconductor device can be improved.

### Brief Description of Drawings

[FIG. 1] FIG. 1 is a plan view of a semiconductor chip that is a semiconductor device according to a first embodiment.
[FIG. 2] FIG. 2 is a perspective view of a main portion of the semiconductor device according to the first embodiment.
[FIG. 3] FIG. 3 is a cross-sectional view of the semiconductor device according to the first embodiment.
[FIG. 4] FIG. 4 is a cross-sectional view of the semiconductor device according to the first embodiment.
[FIG. 5] FIG. 5 is data measured by inventors of the present application.
[FIG. 6] FIG. 6 is an enlarged plan view of the semiconductor device according to the first embodiment.
[FIG. 7] FIG. 7 is an enlarged cross-sectional view of the semiconductor device according to the first embodiment.
[FIG. 8] FIG. 8 is an enlarged cross-sectional view of the semiconductor device according to the first embodiment.
[FIG. 9] FIG. 9 is a large step diagram illustrating an outline of manufacturing steps of the semiconductor device according to the first embodiment.
[FIG. 10] FIG. 10 is a cross-sectional view showing a manufacturing step of the semiconductor device according to the first embodiment.
[FIG. 11] FIG. 11 is a cross-sectional view showing a manufacturing step subsequent to that in FIG. 10.
[FIG. 12] FIG. 12 is a cross-sectional view showing a manufacturing step subsequent to that in FIG. 11.
[FIG. 13] FIG. 13 is a cross-sectional view showing a manufacturing step subsequent to that in FIG. 12.
[FIG. 14] FIG. 14 is a cross-sectional view showing a manufacturing step subsequent to that in FIG. 13.
[FIG. 15] FIG. 15 is a cross-sectional view showing a manufacturing step subsequent to that in FIG. 14.
[FIG. 16] FIG. 16 is a cross-sectional view showing the manufacturing step subsequent to that in FIG. 14.
[FIG. 17] FIG. 17 is a cross-sectional view showing a container used in heat treatment.
[FIG. 18] FIG. 18 is a cross-sectional view showing a manufacturing step subsequent to that in FIG. 15.
[FIG. 19] FIG. 19 is a cross-sectional view showing the manufacturing step subsequent to that in FIG. 16.
[FIG. 20] FIG. 20 is a cross-sectional view showing a manufacturing step subsequent to that in FIG. 18.
[FIG. 21] FIG. 21 is a cross-sectional view showing a manufacturing step subsequent to that in FIG. 20.
[FIG. 22] FIG. 22 is a cross-sectional view showing a manufacturing step subsequent to that in FIG. 21.
[FIG. 23] FIG. 23 is a cross-sectional view showing a manufacturing step subsequent to that in FIG. 22.
[FIG. 24] FIG. 24 is a cross-sectional view showing a manufacturing step subsequent to that in FIG. 23.
[FIG. 25] FIG. 25 is a cross-sectional view showing a manufacturing step subsequent to that in FIG. 24.

### Description of Embodiments

Hereinafter, an embodiment of the invention will be described in detail with reference to drawings. In all the drawings for describing the embodiment, members having the same functions are denoted by the same reference numerals, and a repeated description thereof will be omitted. In addition, in the following embodiment, descriptions of the same or similar parts will not be repeated in principle unless particularly necessary.

In addition, in the drawings used in the embodiment, a hatching may be omitted in a cross-sectional view and may be added in a plan view for easy viewing of the drawings.

In addition, in the following description, "⁻," "⁺," or the like is attached to a notation of an "n-type," but these symbols are symbols indicating relative impurity concentrations. For example, in a case of the n-type, it means that an impurity concentration of an n-type impurity increases in an order of "n⁻", "n", "n⁺" and "n⁺⁺". In addition, a notation of a "p-type" is also the same as in the case of the "n-type."

In addition, in the following description, when a "first angle of 80 degrees to 100 degrees" is, for example, described in order to represent a numerical value range, it means that the "first angle is 80 degrees or more to 100 degrees or less" unless otherwise stated. In addition, an expression of such a numerical value range is not limited to the angle, and the same applies to other elements.

### (First Embodiment)

### <Structure of Semiconductor Device>

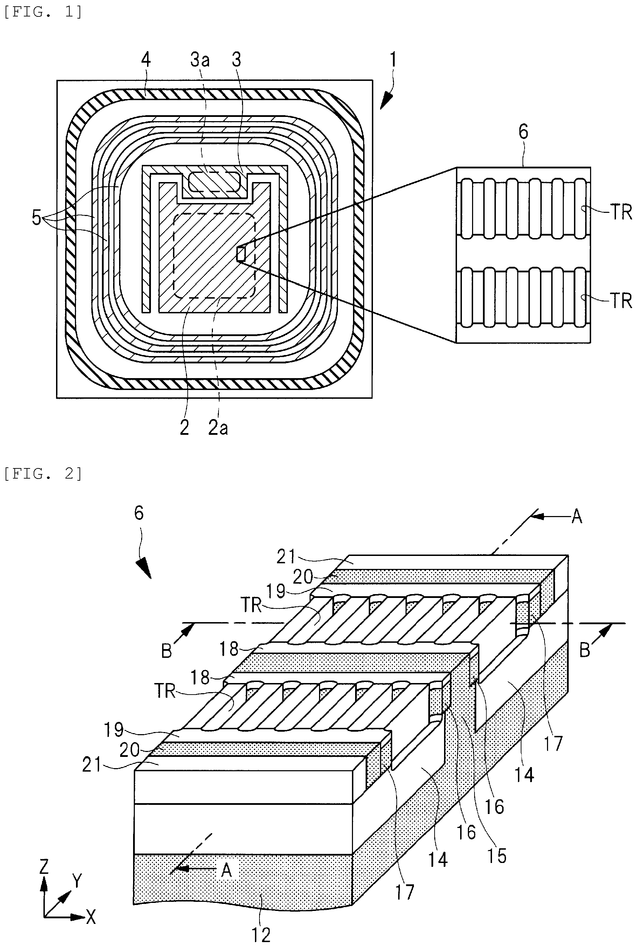

FIG. 1 is a plan view of a semiconductor chip 1 that is a semiconductor device according to a first embodiment. FIG. 1 also shows an enlarged plan view of a part of an active region 6 in which a main semiconductor element of the semiconductor chip 1 is formed.

As shown in FIG. 1, a source wiring electrode 2 and a gate wiring electrode 3 are formed in a central portion of the semiconductor chip 1. The active region 6 is below the source wiring electrode 2, and the main semiconductor element such as an n-type SiC power MISFET is formed inside the active region 6. A plurality of trenches TR, which are formed in a stripe shape in the plan view, are formed in the active region 6, and the SiC power MISFET is formed by using these trenches TR.

A region surrounded by a broken line in the source wiring electrode 2 is a source pad 2a, and a region surrounded by a broken line in the gate wiring electrode 3 is a gate pad 3a. Although not shown here, the semiconductor chip 1 is covered with a protective film, and regions exposed from opening portions formed in the protective film are the source pad 2a and the gate pad 3a. By connecting an external connection terminal such as a bonding wire or a clip (copper plate) to an upper surface of each of the source pad 2a and the gate pad 3a, the semiconductor chip 1 can be electrically connected to another chip, a wiring substrate, or the like.

Three p-type FLRs 5 are formed on an outer periphery of the source wiring electrode 2 and the gate wiring electrode 3, and an n⁺⁺-type guard ring 4 is formed on an outer periphery of the p-type FLRs 5. The plurality of p-type FLRs 5 are formed around the active region 6, so that a maximum electric field portion transfers toward the p-type FLRs 5 and breakdown occurs in an outermost p-type FLR 5 during an off-operation of the SiC power MISFET. Therefore, a breakdown voltage of the SiC power MISFET can be increased. Although the three p-type FLRs 5 are shown in FIG. 1, the number of p-type FLRs 5 is not limited to three, and may be more than or less than three. The n⁺⁺-type guard ring 4 has a function of protecting the SiC power MISFET formed in the active region 6.

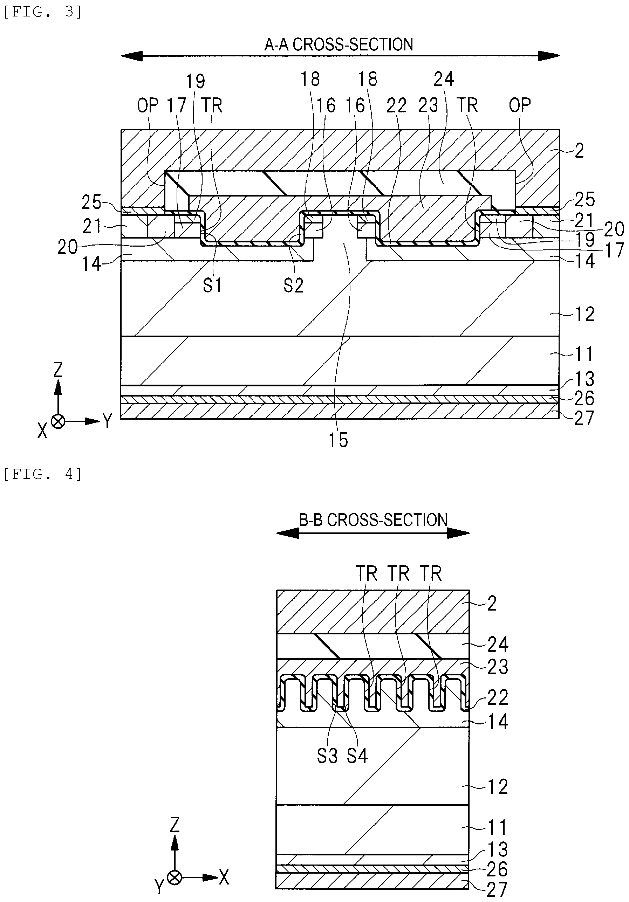

FIG. 2 is a perspective view of a main portion of the semiconductor device according to the first embodiment, and shows the SiC power MISFET that is the semiconductor element formed in the active region 6. FIG. 3 is a cross-sectional view taken along a line A-A shown in FIG. 2, and FIG. 4 is a cross-sectional view taken along a line B-B shown in FIG. 2.

In FIG. 2, only impurity regions exhibiting n-type conductivity are hatched for easy viewing of the drawing. Further, since FIG. 2 mainly shows respective impurity regions formed in the vicinity of an upper surface of an n⁻-type epitaxial layer 12, an n-type semiconductor substrate 11, a gate electrode 23, the source wiring electrode 2, and the like are omitted.

The semiconductor substrate (substrate) 11 used in the first embodiment is a compound semiconductor substrate containing carbon and silicon. Specifically, the semiconductor substrate 11 is an n⁺-type silicon carbide (SiC) substrate and is a 4H-SiC substrate. The n-type semiconductor substrate 11 has a front surface and a back surface that is a surface on an opposite side of the front surface.

An n⁺-type drain region 13 is formed on a back surface side of the n-type semiconductor substrate 11. A silicide layer 26 is formed below the n⁺-type drain region 13, and a drain wiring electrode 27 is formed below the silicide layer 26. The silicide layer 26 is made of, for example, nickel silicide (NiSi). The drain wiring electrode 27 is, for example, a stacked film of a titanium (Ti) film, a nickel (Ni) film, and a gold (Au) film, and a thickness of the drain wiring electrode 27 is, for example, 0.5 µm to 1.0 µm. The drain wiring electrode 27 may be a single-layer film made of one of these films, or may be a conductive film other than these films, instead of being the stacked film of these films.

The drain wiring electrode 27 functions as a drain electrode of the SiC power MISFET. Although not shown, the drain wiring electrode 27 is electrically connected to another chip, a wiring substrate, or the like outside the semiconductor chip 1 via an external connection conductive film of such as a solder ball or a bump electrode.

The n⁻-type epitaxial layer (semiconductor layer) 12, which has an impurity concentration lower than that of the n-type semiconductor substrate 11 and is made of silicon carbide (SiC), is formed on the n-type semiconductor substrate 11. The n⁻-type epitaxial layer 12 functions as a drift layer in the first embodiment.

P⁺-type body regions (impurity regions) 14 are formed in the n⁻-type epitaxial layer 12. The p⁺-type body regions mainly function as a channel region of the SiC power MISFET. The n⁻-type epitaxial layer 12 located between the p⁺-type body regions 14 adjacent to each other in a Y direction constitutes a JFET region (impurity region) 15.

N⁺-type current spreading regions (impurity regions) 16 and 17 each having an impurity concentration higher than that of the n⁻-type epitaxial layer 12 and p⁺-type electric field relaxation regions (impurity regions) 18 and 19 each having an impurity concentration higher than that of the p⁺-type body region 14 are formed in each of the p⁺-type body regions 14. The n⁺-type current spreading region 16 is electrically connected to the n⁺-type drain region 13 via the n⁻-type epitaxial layer 12, and constitutes a part of the drain region of the SiC power MISFET. The n⁺-type current spreading region 17 is electrically connected to an n⁺⁺-type source region 20 described later, and constitutes a part of a source region of the SiC power MISFET.

A part of the n⁺-type current spreading region 16 and a part of the p⁺-type electric field relaxation region 18 extend to the n⁻-type epitaxial layer 12 adjacent to the p⁺-type body region 14. Further, the p⁺-type electric field relaxation region 18 is located above the n⁺-type current spreading region 16, and the p⁺-type electric field relaxation region 19 is located above the n⁺-type current spreading region 17.

Further, a p⁺⁺-type body potential fixing region (impurity region) 21 having an impurity concentration higher than those of the p⁺-type electric field relaxation regions 18 and 19 and the n⁺⁺-type source region (impurity region) 20 having an impurity concentration higher than those of the n⁺-type current spreading regions 16 and 17 are formed in each of the p⁺-type body regions 14.

The n⁺⁺-type source region 20 and the p⁺⁺-type body potential fixing region 21 are electrically connected to the source wiring electrode 2 and applied with a source potential during an operation of the SiC power MISFET. The n⁺-type current spreading region 16 is electrically connected to the drain wiring electrode 27 via the n⁻-type epitaxial layer 12, the n⁺-type drain region 13, and the silicide layer 26, and is applied with a drain potential during the operation of the SiC power MISFET.

The plurality of trenches TR are formed in the n⁻-type epitaxial layer 12 such that each trench TR penetrates the p⁺-type electric field relaxation regions 18 and 19 and the n⁺-type current spreading regions 16 and 17 and reach the p⁺-type body region 14. As shown in FIGS. 2 and 3, each of the plurality of trenches TR extends in the Y direction. As shown in FIGS. 2 and 4, a plurality of trenches TR are formed so as to be adjacent to each other in an X direction.

The gate electrode 23 is embedded inside each of the plurality of trenches TR with a gate insulating film 22 interposed between the gate electrode 23 and the trench TR. The gate insulating film 22 is, for example, an insulating film such as a silicon oxide film, and a thickness of the gate insulating film 22 is, for example, 5 nm to 150 nm. The gate electrode 23 is, for example, a conductive film such as a polycrystalline silicon film, and a thickness of the gate electrode 23 is, for example, 0.01 µm to 4 µm.

A part of the gate electrode 23 is also formed outside the trench TR, and the gate electrodes 23 formed inside the plurality of trenches TR are integrated with each other. As shown in FIG. 3, an end portion of the gate electrode 23 formed outside the trench TR is located above the p⁺-type electric field relaxation region 19 and the n⁺-type current spreading region 17.

Although not shown, the gate electrode 23 is electrically connected to the gate wiring electrode 3 shown in FIG. 1, and is applied with a gate potential during the operation of the SiC power MISFET.

As shown in FIG. 3, in the Y direction, a first side surface S1 of the trench TR is in contact with the p⁺-type electric field relaxation region 19 and the n⁺-type current spreading region 17, and a second side surface S2 of the trench TR, which is a side surface facing the first side surface S1, is in contact with the p⁺-type electric field relaxation region 18 and the n⁺-type current spreading region 16. In addition, as shown in FIG. 4, in the X direction, a third side surface S3 of the trench TR, a fourth side surface S4 of the trench TR which is a side surface facing the third side surface S3, and a bottom surface of the trench TR are in contact with the p⁺-type body region 14.

Thus, a path from the n⁺-type current spreading region 16 to the n⁺-type current spreading region 17 via the p⁺-type body region 14 serves as a current path of the SiC power MISFET. That is, the channel region of the SiC power MISFET is formed in the p⁺-type body region 14 in contact with the third side surface S3, the fourth side surface S4, and the bottom surface of the trench TR, and in particular, the p⁺-type body region 14 interposed between the third side surface S3 and the fourth side surface S4 serves as a main portion of the channel region.

The gate electrode 23 is covered with an interlayer insulating film 24. The interlayer insulating film 24 is, for example, an insulating film such as a silicon oxide film. An opening portion OP that opens above a part of the n⁺⁺-type source region 20 and above the p⁺⁺-type body potential fixing region 21 is formed in the interlayer insulating film 24. A silicide layer 25 made of, for example, nickel silicide (NiSi) is formed above the n⁻-type epitaxial layer 12 inside the opening portion OP.

The source wiring electrode 2 is formed inside the opening portion OP and on the interlayer insulating film 24. The source wiring electrode 2 is formed of a barrier metal film containing, for example, a titanium (Ti) film and titanium nitride (TiN), and a conductive film such as an aluminum (Al) film. The source wiring electrode 2 embedded in the opening portion OP is connected to the n⁺⁺-type source region 20 and the p⁺⁺-type body potential fixing region 21 via the silicide layer 25. In addition, although not shown, the gate wiring electrode 3 shown in FIG. 1 is formed of a conductive film similar to the source wiring electrode 2, and is connected to a part of the gate electrode 23.

In addition, although not shown, the protective film such as a silicon oxide film or a polyimide film is formed on the source wiring electrode 2 and the gate wiring electrode 3, and the regions exposed from the opening portions formed in the protective film are the source pad 2a and the gate pad 3a shown in FIG. 1.

Hereinafter, parameters such as depths and impurity concentrations of components in the first embodiment will be described. Each of the depths (first depth to sixth depth) shown below is a depth from the upper surface of the n⁻-type epitaxial layer 12. In other words, each of these depths is a thickness of each of the impurity regions.

The n-type semiconductor substrate 11 has an impurity concentration of, for example, 1×10¹⁸ cm⁻³ to 1×10²¹ cm⁻³.

The n⁻-type epitaxial layer 12 has a thickness of, for example, 5 µm to 50 µm, and has an impurity concentration of, for example, 1×10¹⁴ cm⁻³ to 1×10¹⁷ cm³.

The n⁺-type drain region 13 has an impurity concentration of, for example, 1×10¹⁹ cm⁻³ to 1×10²¹ cm⁻³.

The p⁺-type body region 14 has a depth (first depth) of, for example, 0.5 µm to 2.0 µm, and has an impurity concentration of, for example, 1×10¹⁶ cm⁻³ to 1×10¹⁹ cm³. In addition, a maximum impurity concentration of the p⁺-type body region 14 is, for example, in a range of 1×10¹⁷ cm⁻³ to 1×10¹⁹ cm³.

The p⁺⁺-type body potential fixing region 21 has a depth (second depth) of, for example, 0.1 µm to 1.0 µm, and has an impurity concentration of, for example, 1×10¹⁹ cm⁻³ to 1×10²¹ cm³.

The n⁺⁺-type source region 20 has a depth (third depth) of, for example, 0.1 µm to 1.0 µm, and has an impurity concentration of, for example, 1×10¹⁹ cm⁻³ to 1×10²¹ cm⁻³.

The n⁺-type current spreading regions 16 and 17 each have a depth (fourth depth) of, for example, 0.1 µm to 1.0 µm, and have an impurity concentration of, for example, 5×10¹⁷ cm⁻³ to 5×10¹⁸ cm⁻³.

The p⁺-type electric field relaxation regions 18 and 19 each have a depth (fifth depth) of, for example, 0.01 µm to 0.5 µm, and have an impurity concentration of, for example, 1×10¹⁷ cm⁻³ to 1×10¹⁹ cm⁻³.

Hereinafter, parameters related to each of the trenches TR shown in FIGS. 3 and 4 will be described. A depth (sixth depth) of the trench TR from the upper surface of the n⁻-type epitaxial layer 12 is shallower than the depth (first depth) of the p⁺-type body region 14, and is, for example, 0.1 µm to 1.5 µm. In addition, a length of the trench TR in a direction (Y direction) parallel to a channel length is, for example, 1.0 µm to 3.0 µm. In addition, a length of the trench TR in a direction (X direction) parallel to a channel width is, for example, about 0.1 µm to 2.0 µm. In addition, an interval between the trenches TR in the direction (X direction) parallel to the channel width is, for example, about 0.1 µm to 2.0 µm.

### <Main Features of Structure of Semiconductor Device>

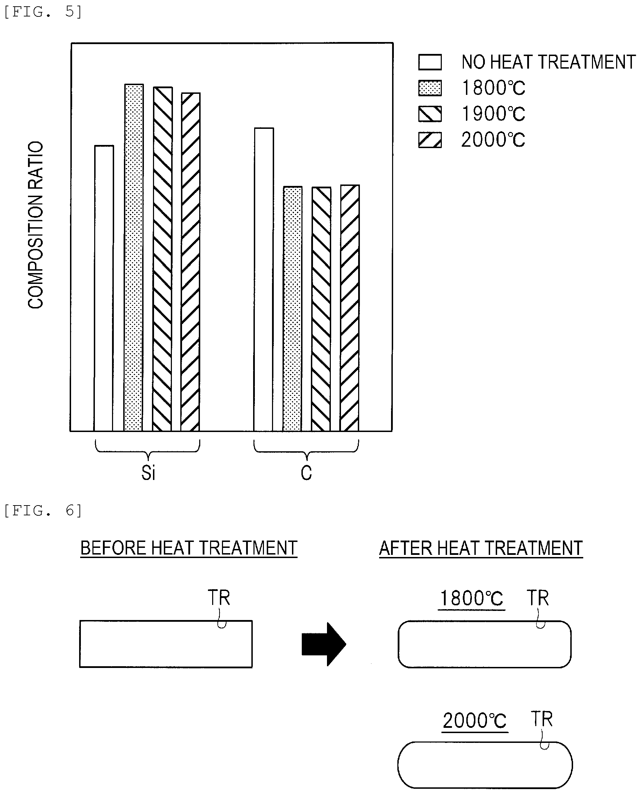

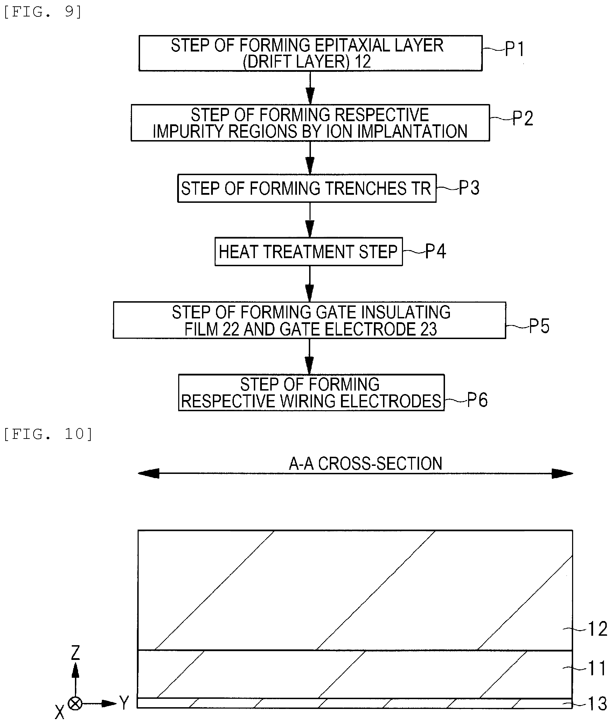

Main features of a structure of the semiconductor device according to the first embodiment will be described below with reference to FIGS. 5 to 8. The structure described here is a structure after heat treatment described later. The heat treatment will be described later in detail with reference to a large step P4 in FIG. 9, and FIGS. 16 to 19.

In the semiconductor device according to the first embodiment, the plurality of trenches TR are formed, and the gate electrode 23 is embedded in each of the trenches TR with the gate insulating film 22 interposed therebetween. Therefore, the p⁺-type body region 14 around the trench TR constitutes the channel region of the SiC power MISFET, and in particular, the p⁺-type body region 14 interposed between both side surfaces (the third side surface S3 and the fourth side surface S4) of the trench TR along the Y direction serves as the main portion of the channel region. The third side surface S3 and the fourth side surface S4 include a (11-20) plane or a (1-100) plane having high channel mobility. Therefore, the SiC power MISFET using a trench gate in the first embodiment can be expected to have higher channel mobility than a planar MISFET in which the trench TR is not formed in the n⁻-type epitaxial layer 12.

In addition, the p⁺-type electric field relaxation region 18 is formed on the n⁺-type current spreading region 16, and the p⁺-type electric field relaxation region 19 is formed on the n⁺-type current spreading region 17. In particular, since the p⁺-type electric field relaxation region 19 is provided at a corner portion of the trench TR on a source side, even if an electric field is concentrated at the corner portion of the trench TR during an on-operation of the SiC power MISFET, a decrease in threshold voltage is prevented. Therefore, a leakage current can be prevented.

In the first embodiment, since the heat treatment is performed in the large step P4 in FIG. 9, a composition ratio (Si/C) of silicon (Si) to carbon (C) is increased in the upper surface of the n⁻-type epitaxial layer 12 outside the trench TR, the bottom surface of the trench TR, and the side surfaces S1 to S4 of the trench TR.

FIG. 5 shows data obtained by measuring the composition ratio of the upper surface of the n⁻-type epitaxial layer 12 by inventors of the present application. Here, a case where the heat treatment is performed in a range of 1800°C to 2000°C is compared with a case where the heat treatment is not performed. As shown in FIG. 5, when the heat treatment is performed, a ratio of silicon is higher than a ratio of carbon (Si > C). As a result, when a formation condition of the gate insulating film is selected, defects caused by carbon at an interface of the gate insulating film can be reduced, and the channel mobility is improved and a channel resistance can be reduced in the SiC power MISFET in the first embodiment.

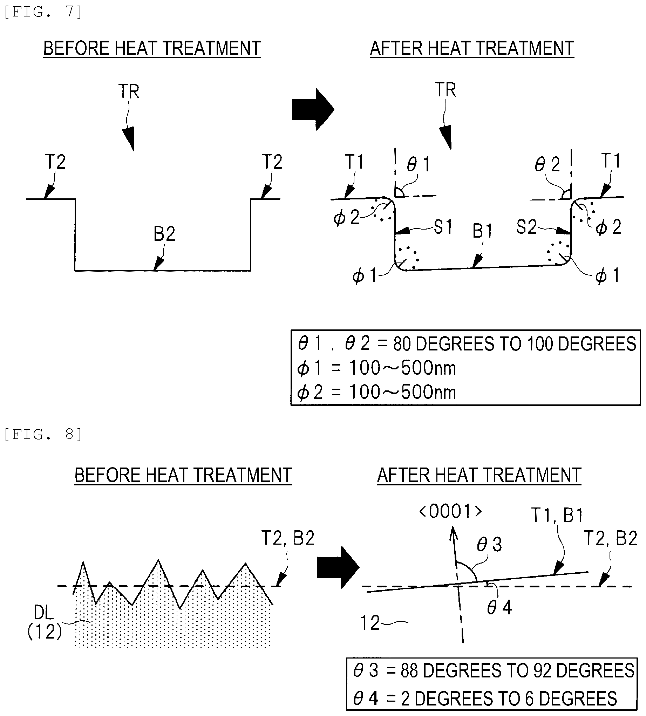

FIG. 6 is an enlarged plan view of a periphery of the trench TR and FIGS. 7 and 8 are enlarged cross-sectional views of the periphery of the trench TR, which show a structure of the trench TR after the heat treatment.

As shown in FIG. 6, a planar shape of the trench TR is substantially a quadrangle immediately after the trench TR is formed, but due to the heat treatment, the planar shape of the trench TR becomes a polygon with removal of corners of the quadrangle, and approaches an elliptical shape with an increase in temperature. That is, the planar shape of the trench TR in the first embodiment is the polygon having more corners than the quadrangle. By increasing the corners in this way, an angle at each of the corners increases, and electric field concentration at each of the corners is easily relaxed. Therefore, a risk of dielectric breakdown of the gate insulating film 22 or the like is reduced, and reliability of the SiC power MISFET is improved.

The SiC is a semiconductor crystal in which a stacking manner of Si and C is likely to change in various ways. A method for manufacturing an epitaxial layer made of only 4H-SiC that is one of polymorphs suitable for power semiconductors is developed. For example, in order to enable transmission of stack information, the epitaxial layer is manufactured on a SiC substrate (SiC substrate having an off angle) whose Si surface, in which Si atoms are on an uppermost surface, is inclined at several degrees with respect to a crystal axis. Such an off angle is, for example, 4 degrees.

On the other hand, when the SiC substrate has the off angle, a crystal plane (stepped crystal plane) having a different orientation corresponding to the off angle appears on an uppermost surface of the epitaxial layer. Depending on growth conditions, surface roughening (defect) such as step bunching occurring due to the off angle is generated. Due to such a defect, a roughness at the interface between the epitaxial layer and the gate insulating film is increased, the channel mobility is decreased due to an increase in roughness scattering, and the channel resistance is increased. Therefore, performance of the semiconductor device may decrease. Further, roughening of the interface of the gate insulating film may cause a decrease in reliability of the gate insulating film.

A drawing before the heat treatment in FIG. 8 is an enlarged cross-sectional view of both a bottom surface B2 of the trench TR and an upper surface T2 of the n⁻-type epitaxial layer 12 outside the trench TR, which are shown in a drawing before the heat treatment in FIG. 7. The upper surface T2 and the bottom surface B2 are often schematically shown as flat surfaces parallel to a horizontal plane (plane formed of the X direction and the Y direction) as indicated by a broken line in FIG. 8, but a surface layer of each of the upper surface T2 and the bottom surface B2 is actually roughened due to an influence of being exposed to a dry etching process or the like. In FIG. 8, the roughened surface layer is shown as a damaged layer DL. A surface roughness of the damaged layer DL is an average roughness in a thickness direction, and a value of the surface roughness is several nanometers, for example, 2 nm to 10 nm. The damaged layer DL having such surface roughness causes the roughness scattering. Here, by performing the heat treatment in the first embodiment, the damaged layer DL is removed, and the surface roughness is improved.

As shown in a drawing after the heat treatment in FIG. 8, flatness of a bottom surface B1 of the trench TR and an upper surface T1 of the n⁻-type epitaxial layer 12 outside the trench TR is improved in the first embodiment. A surface roughness of each of the upper surface T1 and the bottom surface B1 is 1 nm or less. A surface roughness of each of the side surface S1 and the side surface S2 of the trench TR is 1.5 nm or less. Although not shown here, a surface roughness of each of the side surface S3 and the side surface S4 of the trench TR shown in FIG. 4 is also 1.5 nm or less.

An angle θ4 formed by the upper surface T1 and the upper surface T2 before the heat treatment and an angle θ4 formed by the bottom surface B1 and the bottom surface B2 before the heat treatment each are 2 degrees to 6 degrees. That is, each of the upper surface T1 and the bottom surface B1 is inclined within a range of ± 2 degrees (4 degrees) with respect to the Si surface. In other words, an angle θ3 formed by each of the upper surface T1 and the bottom surface B1 and a <0001> direction of the n⁻-type epitaxial layer 12 is 88 degrees to 92 degrees.

As described above, in the first embodiment, since the flatness of the n⁻-type epitaxial layer 12 can be improved and the disturbance of the interface between the n⁻-type epitaxial layer 12 and the gate insulating film 22 can be improved, the performance of the semiconductor device can be improved.

Further, as shown in FIG. 8, the upper surface T1 and the bottom surface B1 in the first embodiment are respectively inclined at the angle θ4 with respect to the upper surface T2 and the bottom surface B2 before the heat treatment. Therefore, as shown in FIG. 7, the upper surface T1 on a side surface S1 side is inclined within a range of an angle θ1 with respect to the side surface S1, and the upper surface T1 on a side surface S2 side is inclined within a range of an angle θ2 with respect to the side surface S2. Further, the angle θ1 is smaller than the angle θ2. The angle θ1 and the angle θ2 are each within a range of 80 degrees to 100 degrees. Although not shown here, the upper surface T1 also has the same relationship with the side surface S3 and the side surface S4.

Further, as shown in a drawing after the heat treatment in FIG. 7, respective corner portions of the trench TR are rounded in the first embodiment. Specifically, a curvature radius ϕ1 of each of a corner portion formed by the bottom surface B1 and the side surface S1 and a corner portion formed by the bottom surface B1 and the side surface S2 is 100 nm to 500 nm. Although not shown here, a curvature radius of each of a corner portion formed by the bottom surface B1 and the side surface S3 and a corner portion formed by the bottom surface B1 and the side surface S4 is also the same.

Further, a curvature radius ϕ2 of each of a corner portion formed by the upper surface T1 and the side surface S1 and a corner portion formed by the upper surface T1 and the side surface S2 is 100 nm to 500 nm. Although not shown here, a curvature radius of each of a corner portion formed by the upper surface T1 and the side surface S3 and a corner portion formed by the upper surface T1 and the side surface S4 is also the same.

As described above, the electric field concentration at the respective corner portions is relaxed by rounding the respective corner portions. Therefore, since the risk of the dielectric breakdown of the gate insulating film 22 or the like is reduced, reliability of the semiconductor device is improved.

The upper surface T1, the bottom surface B1, and the side surfaces S1 to S4 in the first embodiment refer to wall surfaces excluding the corner portions having the above-described curvature radii.

### <Method for Manufacturing Semiconductor Device>

Hereinafter, a method for manufacturing the semiconductor device according to the first embodiment will be described with reference to FIGS. 9 to 25. FIG. 9 is a large step diagram illustrating an outline of the method for manufacturing the semiconductor device. Hereinafter, description will be made by mainly using cross-sectional views taken along the line A-A shown in FIG. 2, but cross-sectional views taken along the line B-B may be used as necessary.

Since parameters such as depths and impurity concentrations of components in the first embodiment are the same as those described above, descriptions of these parameters will be omitted in the following description.

### <<Large Step P1>>

A large step P1 in FIG. 9 will be described. The large step P1 is mainly a step of forming the n⁻-type epitaxial layer 12.

First, as shown in FIG. 10, the n-type semiconductor substrate 11 is prepared. The n-type semiconductor substrate 11 is, for example, a 4H-SiC substrate doped with the n-type impurity such as nitrogen (N). Further, the n-type semiconductor substrate 11 has both surfaces of the Si surface and a C surface, but an upper surface of the n-type semiconductor substrate 11 may be either the Si surface or the C surface.

Next, the n⁻-type epitaxial layer 12 made of silicon carbide (SiC) is formed on the upper surface of the n-type semiconductor substrate 11 by an epitaxial growth method. A SiC epitaxial substrate in which the n⁻-type epitaxial layer 12 is formed on the n-type semiconductor substrate 11 may be purchased in advance. That is, in the first embodiment, the n-type semiconductor substrate 11 on which the n⁻-type epitaxial layer 12 is formed may be prepared by any means.

### <<Large Step P2>>

A large step P2 in FIG. 9 will be described. The large step P2 is mainly a step of forming the respective impurity regions by ion implantation.

First, as shown in FIG. 10, the n⁺-type drain region 13 is formed on the back surface of the n-type semiconductor substrate 11 by doping, for example, nitrogen with an ion implantation method.

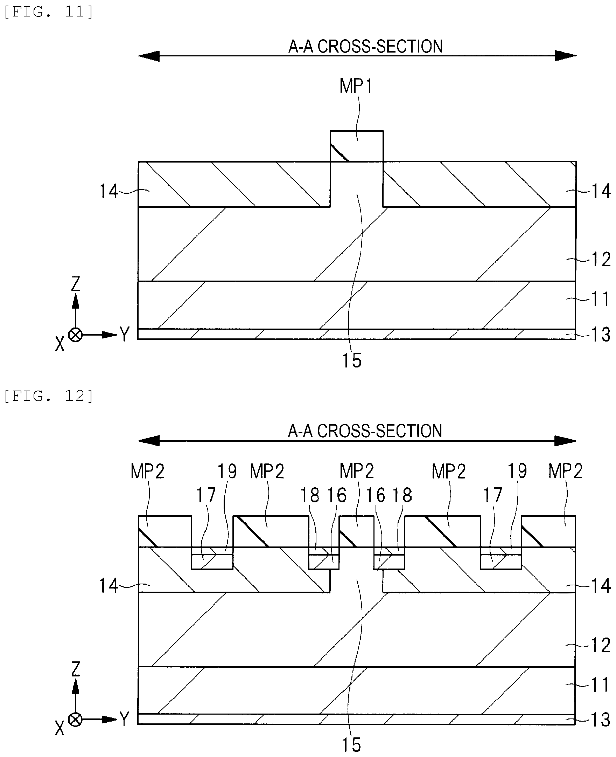

Next, as shown in FIG. 11, a mask pattern MP1 that selectively covers the upper surface of the n⁻-type epitaxial layer 12 is formed. As a material constituting the mask pattern MP1, a SiO₂ film, a Si film, or a SiN film that is an inorganic material, or a resist film or a polyimide film that is an organic material can be used. Further, a thickness of the mask pattern MP1 is, for example, 1.0 µm to 3.0 µm, and a width of the mask pattern MP1 is, for example, about 1.0 µm to 5.0 µm.

Then, the p⁺-type body regions 14 are formed in the n⁻-type epitaxial layer 12 by ion-implanting, for example, aluminum, using the mask pattern MP1 as a mask. The n⁻-type epitaxial layer 12 interposed between the two p⁺-type body regions 14 constitutes the n-type JFET region 15. Thereafter, the mask pattern MP1 is removed.

Although not shown, a pattern having openings at the p⁺-type FLRs 5 shown in FIG. 1 is also formed in the mask pattern MP1. Therefore, the p⁺-type FLRs 5 are also formed in the same step as the step of forming the p⁺-type body regions 14. Further, a structure of an end portion is not limited to the p⁺-type FLR 5, and may be, for example, a junction termination extension (JTE) structure.

Then, as shown in FIG. 12, a mask pattern MP2 that selectively covers the upper surface of the n⁻-type epitaxial layer 12 is formed. A material of the mask pattern MP2 is the same as that of the mask pattern MP1, and a thickness of the mask pattern MP2 is, for example, 0.5 µm to 3.0 µm.

Then, the n⁺-type current spreading region 16 is formed in a region extending across the p⁺-type body region 14 and the n-type JFET region 15 and the n⁺-type current spreading region 17 is formed in the p⁺-type body region 14 by ion-implanting, for example, nitrogen, using the mask pattern MP2 as a mask.

Then, the p⁺-type electric field relaxation region 18 is formed in the region extending across the p⁺-type body region 14 and the n-type JFET region 15 and the p⁺-type electric field relaxation region 19 is formed in the p⁺-type body region 14 by ion-implanting, for example, aluminum, using the mask pattern MP2 as a mask. Thereafter, the mask pattern MP2 is removed.

Here, a region from the n⁺-type current spreading region 16 to the n⁺-type current spreading region 17 constitutes the channel region of the SiC power MISFET, and has, for example, a length of 0.1 µm to 2.0 µm. Since the n⁺-type current spreading region 16 and the n⁺-type current spreading region 17 are formed using the same mask pattern MP2, the channel length (length of the channel region in the Y direction) is less liable to vary among a plurality of SiC power MISFETs. That is, when the n⁺-type current spreading region 16 and the n⁺-type current spreading region 17 are formed using different mask patterns, the channel length varies among a plurality of wafers if mask displacement occurs in either one of the mask patterns. Therefore, as described above, a variation in channel length is prevented by using the same mask pattern MP2.

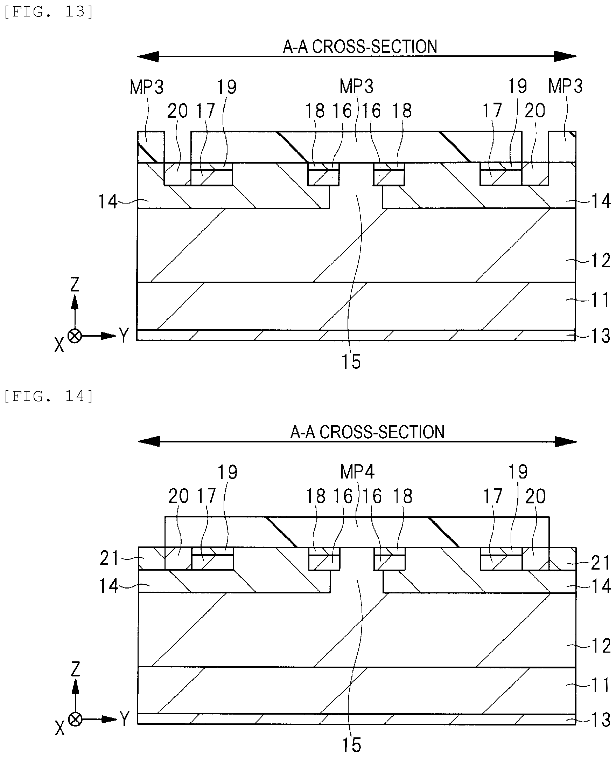

Then, as shown in FIG. 13, a mask pattern MP3 that selectively covers the upper surface of the n⁻-type epitaxial layer 12 is formed. A material of the mask pattern MP3 is the same as that of the mask pattern MP1, and a thickness of the mask pattern MP3 is, for example, 1.0 µm to 5.0 µm.

Then, the n⁺⁺-type source region 20 is formed in the p⁺-type body region 14 by ion-implanting, for example, nitrogen using the mask pattern MP3 as a mask. The n⁺⁺-type source region 20 is connected to the n⁺-type current spreading region 17. Although not shown, a pattern having an opening at the n⁺⁺-type guard ring 4 shown in FIG. 1 is also formed in the mask pattern MP3. Therefore, the n⁺⁺-type guard ring 4 is also formed in the same step as the step of forming the n⁺⁺-type source region 20. Thereafter, the mask pattern MP3 is removed.

Then, as shown in FIG. 14, a mask pattern MP4 that selectively covers the upper surface of the n⁻-type epitaxial layer 12 is formed. A material of the mask pattern MP4 is the same as that of the mask pattern MP1, and a thickness of the mask pattern MP4 is, for example, 0.5 µm to 3.0 µm.

Then, the p⁺⁺-type body potential fixing region 21 is formed in the p⁺-type body region 14 by ion-implanting, for example, aluminum, using the mask pattern MP4 as a mask. Thereafter, the mask pattern MP4 is removed.

### <<Large Step P3>>

A large step P3 in FIG. 9 will be described. The large step P3 is mainly a step of forming the trenches TR.

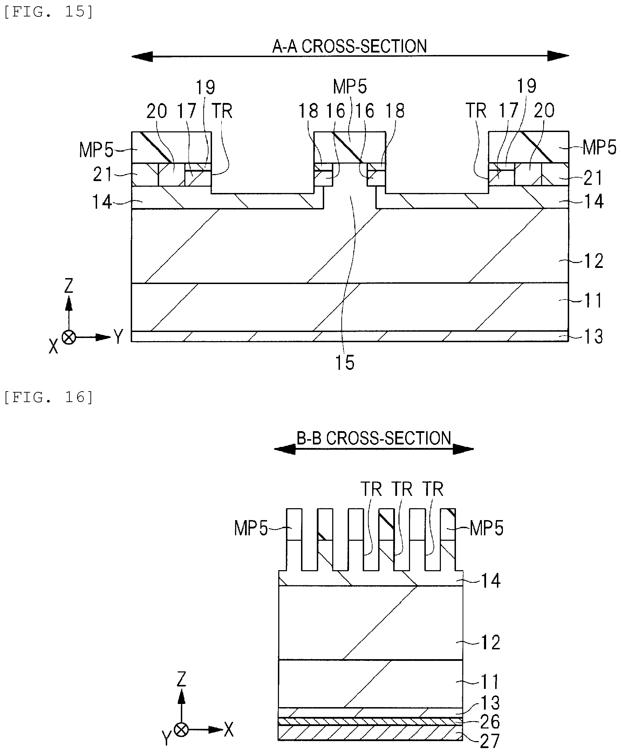

First, as shown in FIGS. 15 and 16, a mask pattern MP5 that selectively covers the upper surface of the n⁻-type epitaxial layer 12 is formed. A material of the mask pattern MP5 is the same as that of the mask pattern MP1, and a thickness of the mask pattern MP6 is, for example, 0.5 µm to 2.0 µm.

Next, by using the mask pattern MP5 as a mask to perform the dry etching process, the trenches TR, each of which penetrates the p⁺-type electric field relaxation regions 18 and 19 and the n⁺-type current spreading regions 16 and 17 and reaches the p⁺-type body region 14, are formed. Thereafter, the mask pattern MP6 is removed.

### <<Large Step P4>>

A large step P4 in FIG. 9 will be described. The large step P4 is a heat treatment step using a container CS.

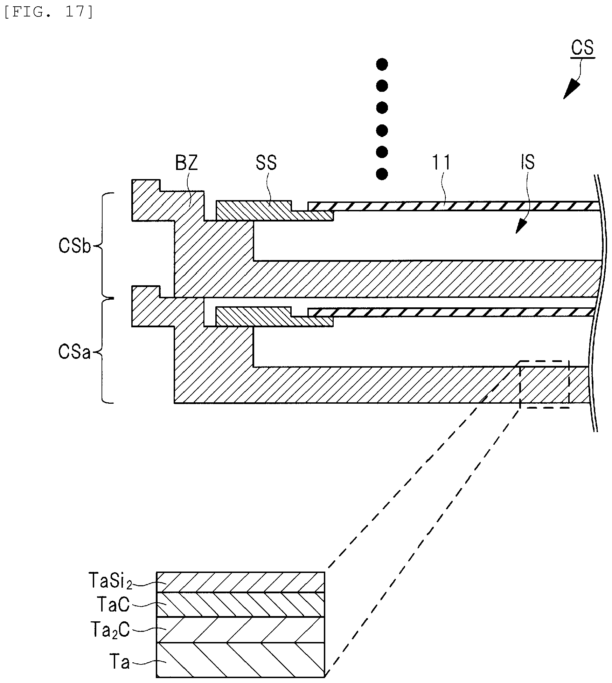

As shown in FIG. 17, the container CS includes a plurality of stacked storage portions. Here, two storage portions CSa and CSb are shown as an example of the plurality of storage portions. Each of the storage portions CSa and CSb includes a bezel (partition wall) BZ and a substrate support portion SS that is attached to the bezel BZ and supports the n-type semiconductor substrate 11. When the heat treatment is to be performed, the n-type semiconductor substrate 11 is provided on the substrate support portion SS and is stored in the container CS. The upper surface of the n-type semiconductor substrate 11 (n⁻-type epitaxial layer 12) in which the trenches TR or the like are formed is located on an internal space IS side.

An enlarged part of a broken line shown in FIG. 17 shows a detailed structure of the bezel BZ. The bezel BZ includes, in order from the internal space IS side, a tantalum silicide layer (TaSi₂ layer), a tantalum carbide layer (TaC layer), a ditantalum carbide layer (Ta₂C layer), and a tantalum layer (Ta layer).

Although a container including a TaC layer, a Ta₂C layer, and a Ta layer is known in the related art, the TaSi₂ layer is further added in the first embodiment in order to make an internal space IS to be in Si vapor pressure. In the first embodiment, the TaSi₂ layer is exposed over a bottom surface and side surfaces of the bezel BZ that constitute the internal space IS.

The heat treatment is performed on the n⁻-type epitaxial layer 12 in a state where the n-type semiconductor substrate 11 is stored in the container CS including such a TaSi₂ layer and the container CS is mounted in a high-temperature vacuum furnace. Specifically, the heat treatment is performed in an atmosphere of an inert gas such as nitrogen or argon, is performed under the Si vapor pressure, and is performed under a condition of 1500°C or higher to 2200°C or lower. More preferably, the heat treatment is performed under a condition of 1600°C or higher to 2000°C or lower. Such heat treatment may be referred to as Si vaper annealing (SiVA).

In the heat treatment, reactions represented by the following Formulas 1 to 5 are performed.

When the n⁻-type epitaxial layer 12 is heated under the Si vapor pressure, SiC in the n⁻-type epitaxial layer 12 becomes Si₂C, SiC₂, or the like, and sublimates. At the same time, Si in a Si atmosphere is bonded to C on the upper surface of the n⁻-type epitaxial layer 12, and the upper surface of the n⁻-type epitaxial layer 12 is flattened by self-assembly. Further, Si released, by heating, from the TaSi₂ layer that is an upper surface layer of the bezel BZ on the internal space IS side also contributes to the reactions. Therefore, pressure of Si in the internal space IS is made uniform.

Formula 1: SiC(s) → Si(v)I + C(s)I

Formula 2: 2SiC(s) → Si(v)II + SiC₂(v)

Formula 3: Ta_{X}Si_{Y}(s) → Ta_{X}Si_{Y-1}(s) + Si(v) III

Formula 4: SiC(s) + Si(v)I + Si(v)II + Si(v)III → Si₂C(v)

Formula 5: C(s)I + Si(v)I + Si(v)II + Si(v)III → Si₂C(v)

As described above, due to the heat treatment using the container CS, a surface layer of the n⁻-type epitaxial layer 12 becomes rich in Si as shown in FIG. 5, and is flattened. Further, the corner portions of the trench TR are rounded. Further, ions implanted into the n-type semiconductor substrate 11 or the n⁻-type epitaxial layer 12 are activated. The surface layer of the n⁻-type epitaxial layer 12 is damaged by the dry etching process during forming of the trench TR, and such damage causes crystal defects. However, such crystal defects are also recovered by the heat treatment. In the first embodiment, these effects can be obtained by performing the heat treatment once.

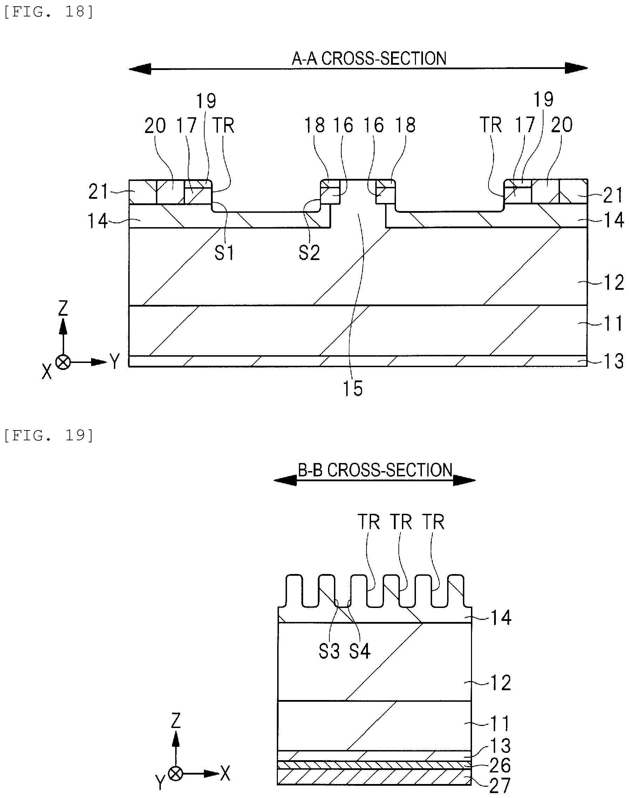

FIGS. 18 and 19 show a structure of the semiconductor device obtained after the heat treatment is performed in a state in FIGS. 15 and 16. As described above, the corner portion formed by the bottom surface and each of the side surfaces S1 to S4 of the trench TR, and the corner portion formed by the upper surface of the n⁻-type epitaxial layer 12 outside the trench TR and each of the side surfaces S1 to S4 are rounded.

For the detailed shapes of the trench TR before and after the heat treatment, refer to the descriptions in FIGS. 6 to 8.

As a modification, the heat treatment may be performed in a state where a carbon layer (graphene cap) is formed on the upper surface of the n⁻-type epitaxial layer 12. In this case, since the carbon layer is removed during the heat treatment, a step of removing the carbon layer is not necessary.

Further, a method for adjusting the inert gas may be any method, and an appropriate method can be used. For example, inert gas pressure may be constant or may be changed. When the inert gas pressure is changed, fine adjustment such as first increasing an etching rate for rounding and then reducing the etching rate can be performed.

Further, instead of the TaSi₂ layer that is an uppermost surface of the bezel BZ, solid Si may be disposed in the container CS.

### <<Large Step P5>>

A large step P5 in FIG. 9 will be described. The large step P5 is mainly a step of forming the gate insulating film 22 and the gate electrode 23.

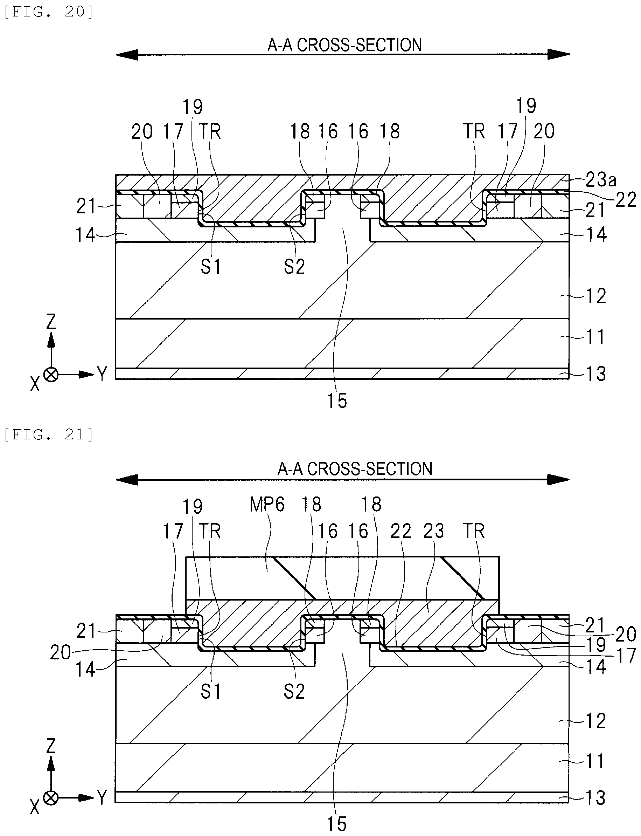

As shown in FIG. 20, the gate insulating film 22, which is the insulating film such as the silicon oxide film, is formed on the side surfaces and the bottom surface of the trench TR and on the upper surface of the n⁻-type epitaxial layer 12 by, for example, a CVD method. Next, a conductive film 23a such as a polycrystalline silicon film, which is doped with, for example, an n-type or p-type impurity, is formed on the gate insulating film 22 by, for example, the CVD method.

Then, as shown in FIG. 21, a mask pattern MP6 that selectively covers an upper surface of the conductive film 23a is formed. A material of the mask pattern MP6 is the same as that of the mask pattern MP1, and a thickness of the mask pattern MP7 is, for example, 0.5 µm to 2.0 µm.

Then, by using the mask pattern MP6 as a mask to perform the dry etching process, the conductive film 23a exposed from the mask pattern MP6 is removed, and the gate electrode 23 obtained by processing the conductive film 23a is formed. Thereafter, the mask pattern MP7 is removed.

### <<Large Step P6>>

A large step P6 in FIG. 9 will be described. The large step P5 is mainly a step of forming wiring electrodes such as the source wiring electrode 2.

First, as shown in FIG. 21, the interlayer insulating film 24, which is made of, for example, the silicon oxide film, is formed on the n⁻-type epitaxial layer 12 by, for example, the CVD method so as to cover the gate electrode 23. Thereafter, if necessary, the interlayer insulating film 24 may be polished by using a chemical mechanical polishing (CMP) method or the like so as to flatten an upper surface of the interlayer insulating film 24.

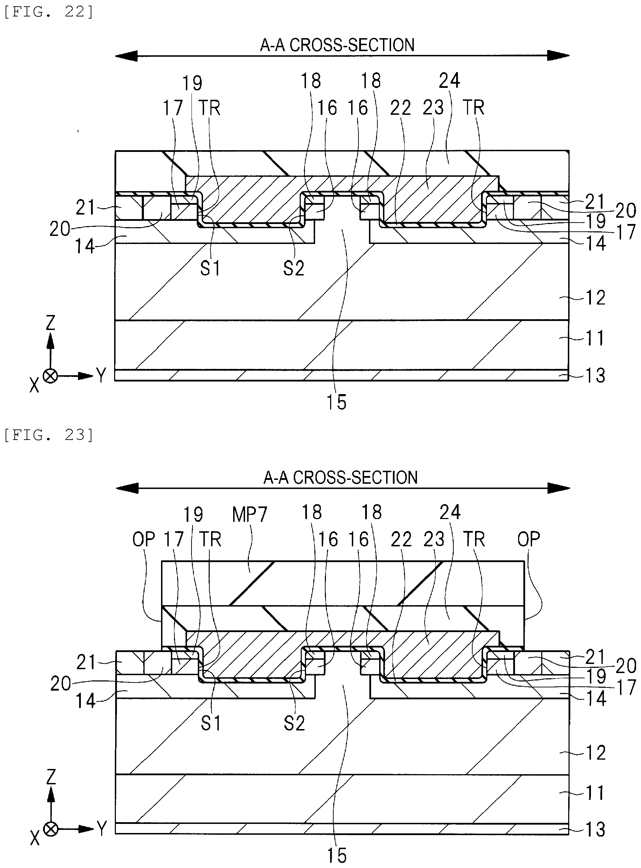

Then, as shown in FIG. 23, a mask pattern MP7 that covers the gate electrode 23 and selectively covers a part of the n⁻-type epitaxial layer 12 is formed. A material of the mask pattern MP7 is the same as that of the mask pattern MP1, and a thickness of the mask pattern MP7 is, for example, 1.0 µm to 3.0 µm.

Then, by using the mask pattern MP7 as a mask to perform the dry etching process or a wet etching process, the interlayer insulating film 24 and the gate insulating film 22 exposed from the mask pattern MP7 are removed, and the opening portion OP is formed in the interlayer insulating film 24. Here, the gate electrode 23 is covered with the interlayer insulating film 24, and a part of the n⁺⁺-type source region 20 and the p⁺⁺-type body potential fixing region 21 are exposed at a bottom portion of the opening portion OP. Although not shown, an opening pattern for embedding the gate wiring electrode 3 shown in FIG. 1 is also formed in the mask pattern MP7 formed on a part of the gate electrode 23. Therefore, in the same step as a step of forming the opening portion OP, an opening portion for exposing a part of the gate electrode 23 is also formed in the interlayer insulating film 24. Thereafter, the mask pattern MP7 is removed.

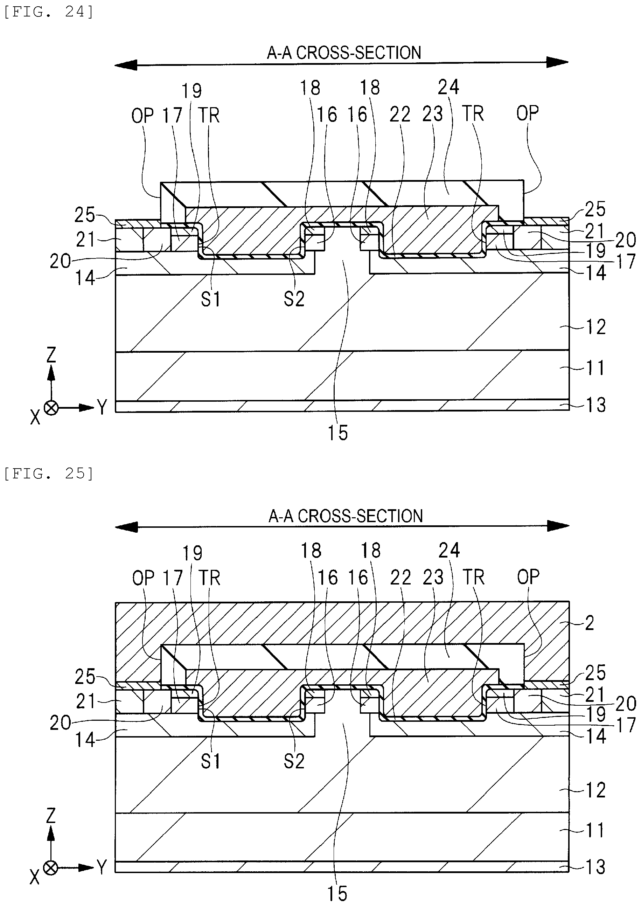

Then, as shown in FIG. 24, the silicide layer 25 is formed in the opening portion OP and on upper surfaces of a part of the n⁺⁺-type source region 20 and the p⁺⁺-type body potential fixing region 21. In order to form the silicide layer 25, a metal film such as a nickel (Ni) film is first deposited on the interlayer insulating film 24 including an inside of the opening portion OP by, for example, a sputtering method. A thickness of the metal film is, for example, about 0.05 µm.

Then, by performing heat treatment on the metal film at 600°C to 1000°C, a material contained in the metal film reacts with a material contained in the n⁺⁺-type source region 20 and the p⁺⁺-type body potential fixing region 21, and the silicide layer 25 made of nickel silicide (NiSi) is formed as a compound of these materials. Although not shown, the silicide layer 25 is also formed on a bottom surface of the opening portion formed on a part of the gate electrode 23. Thereafter, the unreacted metal film is removed by a wet etching process using a solution containing, for example, sulfuric acid and hydrogen peroxide solution.

Then, as shown in FIG. 25, a barrier metal film made of a stacked conductive film such as a titanium film and a titanium nitride film is formed inside the opening portion OP and on the interlayer insulating film 24 by, for example, the sputtering method. Then, a conductive film such as an aluminum film is formed on the barrier metal film by, for example, the sputtering method. Then, the conductive film and the barrier metal film are selectively patterned by a photolithography technique and the dry etching process. As a result, the source wiring electrode 2 including the conductive film and the barrier metal film is formed. The source wiring electrode 2 embedded inside the opening portion OP is connected to a part of the n⁺⁺-type source region 20 and the p⁺⁺-type body potential fixing region 21.

Although not shown, the opening portion for exposing a part of the gate electrode 23 is also formed in the interlayer insulating film 24 as described above. The gate wiring electrode 3 shown in FIG. 1 is formed in the same step as that of the source wiring electrode 2, and is formed in the opening portion.

Thereafter, although not shown, the protective film such as the silicon oxide film or the polyimide film is formed on the source wiring electrode 2 and the gate wiring electrode 3, and the opening portions for exposing a part of the source wiring electrode 2 and a part of the gate wiring electrode 3 are formed in the protective film. The regions exposed from the opening portions are the source pad 2a and the gate pad 3a shown in FIG. 1.

After the above steps, a structure shown in FIG. 3 is obtained by forming the silicide layer 26 and the drain wiring electrode 27 on the back surface of the n-type semiconductor substrate 11.

First, a metal film such as a nickel (Ni) film is formed on the n⁺-type drain region 13 by, for example, the sputtering method. A thickness of the metal film is, for example, 0.1 µm. Next, heat treatment using a laser is performed on the metal film. Due to the heat treatment, the metal film reacts with the n⁺-type drain region 13, and the silicide layer 26, which is a compound of a material contained in the metal film and a material contained in the n⁺-type drain region 13, is formed on an entire lower surface of the n⁺-type drain region 13. The silicide layer 26 is made of, for example, nickel silicide (NiSi). Thereafter, the unreacted metal film that is not silicided is removed by, for example, the wet etching process.

Then, the drain wiring electrode 27 is formed on a lower surface of the silicide layer 26. The drain wiring electrode 27 is obtained by sequentially stacking the titanium film, the nickel film, and the gold film with, for example, the sputtering method. The drain wiring electrode 27 may be a single-layer film made of one of these films, or may be a conductive film other than these films, instead of being a stacked film of these films.

As described above, the semiconductor device according to the first embodiment is manufactured.

The invention made by the inventors of the present application has been specifically described above based on the embodiment, but the invention is not limited to the above embodiment, and various modifications can be made without departing from the scope of the invention.

### Reference Sign List

1: semiconductor chip
2: source wiring electrode
2a: source pad
3: gate wiring electrode
3a: gate pad
4: n⁺⁺-type guard ring
5: p⁻-type floating field limiting ring (FLR)
6: active region
11: n-type semiconductor substrate
12: n⁻-type epitaxial layer
13: n⁺-type drain region
14: p⁺-type body region
15: n-type JFET region
16: n⁺-type current spreading region
17: n⁺-type current spreading region
18: p⁺-type electric field relaxation region
19: p⁺-type electric field relaxation region
20: n⁺⁺-type source region
21: p⁺⁺-type body potential fixing region
22: gate insulating film
23: gate electrode
23a: conductive film
24: interlayer insulating film
25: silicide layer
26: silicide layer
27: drain wiring electrode
B1, B2: bottom surface
BZ: bezel
CS: container
CSa, CSb: storage portion
DL: damaged layer
IS: internal space
MP1 to MP7: mask pattern
OP: opening portion
P1 to P6: large step
S1 to S4: side surface
SS: substrate support portion
T1, T2: upper surface
TR: trench

## Claims

1. A semiconductor device, comprising:
a semiconductor substrate of a first conductivity type made of silicon carbide;
a first semiconductor layer of the first conductivity type formed on the semiconductor substrate and made of silicon carbide;
a first impurity region of a second conductivity type formed in the first semiconductor layer, the second conductivity type being opposite to the first conductivity type;
a second impurity region of the first conductivity type and a third impurity region of the first conductivity type each formed in the first impurity region and having an impurity concentration higher than that of the first semiconductor layer;
a trench formed so as to penetrate the second impurity region and the third impurity region; and
a gate electrode formed in the trench with a gate insulating film interposed between the gate electrode and the trench, wherein
the trench has a bottom surface located in the first impurity region, a first side surface in contact with the second impurity region, and a second side surface in contact with the third impurity region and facing the first side surface,
a ratio of silicon is higher than a ratio of carbon in an upper surface of the first semiconductor layer outside the trench, and the bottom surface, the first side surface, and the second side surface of the trench, and
an angle θ1 at which the upper surface of the first semiconductor layer on a first side surface side is inclined with respect to the first side surface is smaller than an angle θ2 at which the upper surface of the first semiconductor layer on a second side surface side is inclined with respect to the second side surface.

2. The semiconductor device according to claim 1, wherein
the angle θ1 and the angle θ2 are each within a range of 80 degrees or more to 100 degrees or less.

3. The semiconductor device according to claim 1, wherein
a surface roughness of the upper surface of the first semiconductor layer or the bottom surface of the trench is 1 nm or less.

4. The semiconductor device according to claim 3, wherein
a surface roughness of the first side surface or the second side surface is 1.5 nm or less.

5. The semiconductor device according to claim 1, wherein
a planar shape of the trench is a polygon having more corners than a quadrangle.

6. The semiconductor device according to claim 1, wherein
an angle θ3 formed by the upper surface of the first semiconductor layer or the bottom surface of the trench and a <0001> direction of the first semiconductor layer is 88 degrees to 92 degrees.

7. The semiconductor device according to claim 1, wherein
a curvature radius ϕ1 of a first corner portion formed by the bottom surface and the first side surface of the trench is 100 nm to 500 nm.

8. The semiconductor device according to claim 7, wherein
a curvature radius ϕ2 of a second corner portion formed by the upper surface of the first semiconductor layer and the first side surface is 100 nm to 500 nm.

9. The semiconductor device according to claim 1, wherein
the first impurity region constitutes a channel region of a MISFET,
the second impurity region constitutes a part of a source region of the MISFET, and
the third impurity region constitutes a part of a drain region of the MISFET.

10. The semiconductor device according to claim 8, wherein
a fourth impurity region of the second conductivity type having an impurity concentration higher than that of the first impurity region is formed above the second impurity region, and
a fifth impurity region of the second conductivity type having an impurity concentration higher than that of the first impurity region is formed above the third impurity region.

11. A method for manufacturing a semiconductor device, the method comprising:
a step (a) of preparing a semiconductor substrate of a first conductivity type on which an epitaxial layer of the first conductivity type is formed;
a step (b) of forming, in the epitaxial layer, a first impurity region of a second conductivity type opposite to the first conductivity type;
a step (c) of forming, in the first impurity region, a second impurity region of the first conductivity type and a third impurity region of the first conductivity type each having an impurity concentration higher than that of the epitaxial layer;
a step (d) of forming a trench so as to penetrate the second impurity region and the third impurity region, the trench having a bottom surface located in the first impurity region, a first side surface in contact with the second impurity region, and a second side surface facing the first side surface and in contact with the third impurity region;
a step (e) of performing heat treatment on the epitaxial layer after the step (d);
a step (f) of forming a gate insulating film in the trench after the step (e); and
a step (g) of forming a gate electrode on the gate insulating film such that the gate electrode is embedded in the trench, wherein
the heat treatment in the step (e) is performed in a state where the semiconductor substrate is stored in a container including a tantalum silicide layer, and is performed under a condition of 1500°C or higher to 2200°C or lower.
